(19) Europäisches Patentamt
European Patent Office
Office européen des brevets

(11) **EP 2 824 836 A2**

(12) **EUROPEAN PATENT APPLICATION**

(43) Date of publication:
**14.01.2015 Bulletin 2015/03**

(51) Int Cl.:
**H03K 17/081** (2006.01)   **H03K 17/082** (2006.01)
**H03K 17/10** (2006.01)

(21) Application number: **14175711.2**

(22) Date of filing: **04.07.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **12.07.2013   US 201361845629 P**

(71) Applicant: **Delta Electronics, Inc.**
**Taoyuan Hsien 333 (TW)**

(72) Inventor: **Yang, Chang-Jing**
**Taoyuan Hsien 333 (TW)**

(74) Representative: **Robinson, Nigel Alexander Julian**
**D Young & Co LLP**
**120 Holborn**
**London EC1N 2DY (GB)**

(54) **Cascode switch device**

(57)     A cascode switch device is provided. The cascode switch device includes a high voltage, HV, transistor (10) having a first drain electrode (D1), a first source electrode (S1), and a first gate electrode (G1) and a low voltage, LV, transistor (12) cascoded with the HV transistor (10) and having a second drain electrode (D2), a second source electrode (S2), and a second gate electrode (G2). A first ratio of an equivalent capacitance of a second drain-to-source capacitance (120) between the second drain and the second source electrodes (D2, S2), a gate-to-drain capacitance (122) between the second gate and the second drain electrodes (G2, D2) and a gate-to-source capacitance (102) between the first gate and the first source electrodes (G1, S1) to a first drain-to-source capacitance (100) between the first source and the first drain electrodes (S1, D1) being based on a second ratio of a drain voltage (Vss) of the HV transistor (10) to a break-down voltage of the LV transistor (12) so as to provide voltage protection for the LV transistor (12).

FIG. 2

## Description

### BACKGROUND

Field of Invention

The present invention relates to a technology of an electronic circuitry. More particularly, the present invention relates to a cascode switch device.

Description of Related Art

In power management applications, a normally-on device can be cascaded with a low voltage device to produce an enhancement mode cascode switch device. However, the utility and durability of such a cascode switch device can be limited according to the characteristics of the low voltage device included therein. For example, the durability of the cascode switch device may be limited by the breakdown voltage of the low voltage device. In order to render such cascode switch devices suitable for operation in power management systems, where high voltage spikes may present, the cascode switch device should be configured to provide a voltage protection mechanism for the low voltage device.

Accordingly, what is needed is a cascode switch device to address the above issues.

### SUMMARY

An object of the present invention is to provide a cascode switch device. The cascode switch device includes a high voltage (HV) transistor and a low voltage (LV) transistor. The high voltage transistor has a first drain electrode, a first source electrode, and a first gate electrode. The low voltage transistor has a second drain electrode, a second source electrode, and a second gate electrode, the low voltage transistor cascoded with the high voltage transistor such that the first source electrode is electrically connected to the second drain electrode. The casode switch device has a first drain-to-source capacitance between the first source electrode and the first drain electrode, a gate-to-source capacitance between the first gate electrode and a first source electrode, a second drain-to-source capacitance between the second drain electrode and the second source electrode, and a gate-to-drain capacitance between the second gate electrode and the second drain electrode. A first ratio of an equivalent capacitance of the second drain-to-source capacitance, the gate-to-drain capacitance and the gate-to-source capacitance to the first drain-to-source capacitance being based on a second ratio of a drain voltage of the high voltage transistor to a break-down voltage of the low voltage transistor so as to provide voltage protection for the low voltage transistor.

Another aspect of the present invention is to provide a cascode switch device. The cascode switch device includes a normally-on high voltage transistor and a normally-off low voltage transistor. The normally-on high voltage transistor has a first drain electrode, a first source electrode, and a first gate electrode. The normally-off low voltage transistor has a second drain electrode, a second source electrode, and a second gate electrode, the normally-off low voltage transistor cascoded with the normally-on high voltage transistor. The casode switch device has a first drain-to-source capacitance between the first source electrode and the first drain electrode, a gate-to-source capacitance between the first gate electrode and a first source electrode, a second drain-to-source capacitance between the second drain electrode and the second source electrode, and a gate-to-drain capacitance between the second gate electrode and the second drain electrode. A first ratio of an equivalent capacitance of the second drain-to-source capacitance, the gate-to-drain capacitance and the gate-to-source capacitance to the first drain-to-source capacitance being based on a second ratio of a drain voltage of the normally-on high voltage transistor to a break-down voltage of the normally-off low voltage transistor so as to provide voltage protection for the normally-off low voltage transistor.

These and other features, aspects, and advantages of the present invention will become better understood with reference to the following description and appended claims.

It is to be understood that both the foregoing general description and the following detailed description are by examples, and are intended to provide further explanation of the invention as claimed.

### BRIEF DESCRIPTION OF THE DRAWINGS

The invention can be more fully understood by reading the following detailed description of the embodiment, with reference made to the accompanying drawings as follows:

FIG. 1 is diagram of a circuit diagram of a cascode switch device in an embodiment of the present invention;

FIG. 2 is a diagram of a more detail representation of the cascode switch device illustrated in FIG. 1;

FIG. 3 is a diagram of an equivalent circuit of the capacitors in FIG. 2 in an embodiment of the present invention;

FIG. 4 is a diagram of a circuit diagram of a cascode switch device in an embodiment of the present invention;

FIG. 5 is a diagram of an equivalent circuit of the capacitors in FIG. 4 in an embodiment of the present invention;

FIG. 6 is a diagram of a circuit diagram of a cascode switch device in an embodiment of the present invention; and

FIG. 7 is a diagram of a circuit diagram of a cascode switch device in an embodiment of the present invention.

## DETAILED DESCRIPTION

Reference will now be made in detail to the present embodiments of the invention, examples of which are illustrated in the accompanying drawings. Wherever possible, the same reference numbers are used in the drawings and the description to refer to the same or like parts.

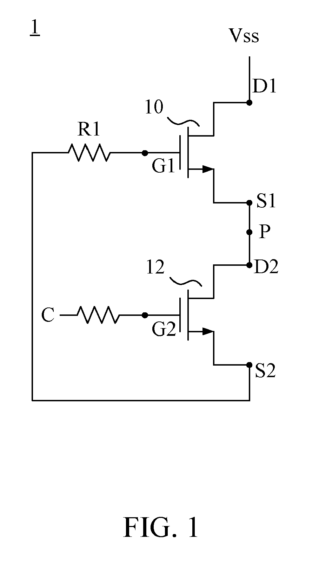

FIG. 1 is diagram of a circuit diagram of a cascode switch device 1 in an embodiment of the present invention. The cascode switch device 1 includes a high voltage (HV) transistor 10 and a low voltage (LV) transistor 12.

In an embodiment, the high voltage transistor 10 is a III-nitride power transistor that may comprise an active layer formed of a plurality of stacked nitride-based semiconductor layers, such as a gallium nitride (GaN) layer and a alumin gallium nitride (AlGaN) layer stacked on the gallium nitride layer, and may be implemented as an insulated-gate FET (IGFET) or as a heterostructure FET (HFET), for example. In an embodiment, the III-nitride power transistor may be formed of a metal-insulator-semiconductor FET, such as a metal-oxide-semiconductor FET (MOSFET). Moreover, in an embodiment, the high voltage transistor 10 may be configured to sustain a drain voltage of approximately 600V and having a gate rating of approximately 40V.

In an embodiment, the low voltage transistor 12 is a silicon-based or a nitride-based field-effect transistor. Moreover, in an embodiment, the low voltage transistor 12 is a nitride-based transistor, e.g. a nitride-based FET and the high voltage transistor 10 and the low voltage transistor 12 are monolithically formed on a same substrate. In another embodiment, the high voltage transistor 10 and the low voltage transistor 12 are located on different chips and packaged in one packaging device.

In an embodiment, the high voltage transistor 10 is a normally-on device and the low voltage transistor 12 is a normally-off device.

As illustrated in FIG. 1, the high voltage transistor 10 includes a first drain electrode D1, a first source electrode S1 and a first gate electrode G1. The low voltage transistor 12 includes a second drain electrode D2, a second source electrode S2 and a second gate electrode G2. The first drain electrode D1 of the high voltage transistor 10 is electrically connected to a system voltage Vss. The first source electrode S1 of the high voltage transistor 10 is electrically connected to the second drain electrode D2 of the low voltage transistor 12 at node P. In an embodiment of the invention, the first gate electrode G1 of the high voltage transistor 10 is electrically connected to the second source electrode S2 of the low voltage transistor 12. In an embodiment, the first gate electrode G1 is electrically connected to the second source electrode S2 through a resistor R1, as illustrated in FIG. 1.

In an embodiment, the second gate electrode G2 of the low voltage transistor 12 receives a control signal C for controlling the operation of the cascode switch device 1.

It is noted that the material, the structure and the related parameters mentioned above are merely an example. In other embodiments, the high voltage transistor 10 and the low voltage transistor 12 may be formed by using other material, structures and parameters. For example, in an embodiment, the high voltage transistor 10 and the low voltage transistor 12 can be both nitride-based FETs.

The operation of the cascode switch device 1 is described by reference to specific, but merely exemplary parameters. For example, when the high voltage transistor 10 is on, a few volts will develop across the low voltage transistor 12. The voltage is thus inverted and applied to the first gate electrode G1 of the high voltage transistor 10. In response, the high voltage transistor 10 will turn off and any additional increase in the voltage of the first drain electrode D1 will be sustained across the first drain electrode D1 and the first source electrode S1 of the high voltage transistor 10. Consequently, the low voltage transistor 12 will typically not be require to sustain a voltage beyond the few volts mentioned above.

In order to provide effective voltage protection for low voltage transistor 12, it is important to more reliably establish that the voltage at the second drain electrode D2 of the low voltage transistor 12 will not rise beyond the rated breakdown voltage of the low voltage transistor 12 (e.g., approximately 30V to 40V).

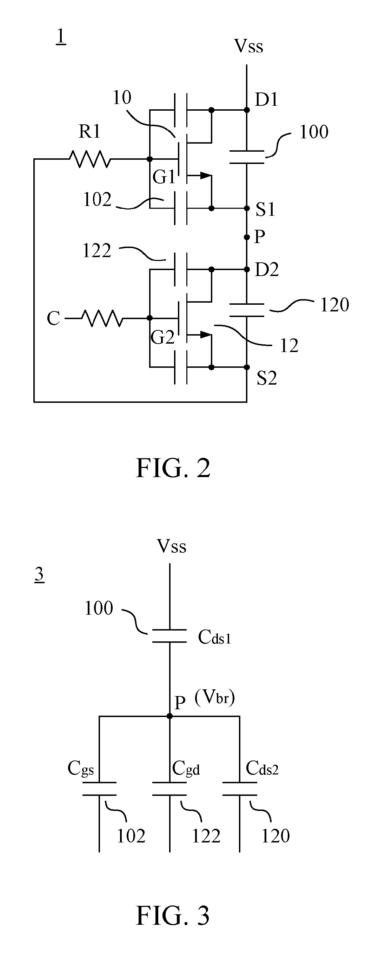

FIG. 2 is a diagram of a more detail representation of the cascode switch device 1 illustrated in FIG. 1.

The high voltage transistor 10 has a first drain-to-source capacitance Cds1 between the first source electrode S1 and the first drain electrode D1. The first drain-to-source capacitance Cds1 can be either contributed by an internal capacitance of the high voltage transistor 10, or contributed by the internal capacitance of the high voltage transistor 10 together with at least one external electronic component. In the present embodiment, the first drain-to-source capacitance Cds1 is contributed by an internal capacitance Cds_gan of a drain-to-source equivalent capacitor 100 of the high voltage transistor 10.

Moreover, the high voltage transistor 10 has a gate-to-source capacitance Cgs between the first source electrode S1 and the first gate electrode G1. Similarly, the gate-to-source capacitance Cgs can be either contributed by an internal capacitance of the high voltage transistor 10, or contributed by the internal capacitance of the high voltage transistor 10 together with at least one external electronic component. In the present embodiment, the gate-to-source capacitance Cgs is contributed by an internal capacitance Cgs_gan of a gate-to-source equivalent capacitor 102 of the high voltage transistor 10.

The low voltage transistor 12 has a second drain-to-source capacitance Cds2 between the second source electrode S2 and the second drain electrode D2. Similarly, the second drain-to-source capacitance Cds2 can be either contributed by an internal capacitance of the low voltage transistor 12, or contributed by the internal capacitance of the low voltage transistor 12 together with at least one external electronic component. In the present embodiment, the second drain-to-source capacitance Cds2 is contributed by an internal capacitance Cds_si of a drain-to-source equivalent capacitor 120 of the low voltage transistor 12.

Moreover, the low voltage transistor 12 has a gate-to-drain capacitance Cgd between the second gate electrode G2 and the second drain electrode D2. Similarly, the gate-to-drain capacitance Cgd can be either contributed by an internal capacitance of the low voltage transistor 12, or contributed by the internal capacitance of the low voltage transistor 12 together with at least one external electronic component. In the present embodiment, the gate-to-drain capacitance Cgd is contributed by an internal capacitance Cgd_si of a gate-to-drain equivalent capacitor 122 of the low voltage transistor 12.

FIG. 3 is a diagram of an equivalent circuit 3 of the capacitors in FIG. 2 in an embodiment of the present invention. In FIG. 3, the capacitances of these capacitors are labeled.

In an embodiment, the equivalent capacitance of the lower part of the equivalent circuit 3 is equal to the sum of the second drain-to-source capacitance Cds2, the gate-to-drain capacitance Cgd and the gate-to-source capacitance Cgs, which is $C_{ds2} + C_{gd} + C_{gs}$. Moreover, the equivalent capacitance of the upper part of the equivalent circuit 3 is equal to the first drain-to-source capacitance Cds1.

During the transient operation, the voltage Vp at the point P, where the second drain electrode D2 of the low voltage transistor 12 is connected to, is set by the ratio between the equivalent capacitances of the upper and the lower part of the equivalent circuit 3:

$$V_p \propto \left( \left( C_{ds1} \right) \middle/ \left( C_{ds2} + C_{gd} + C_{gs} \right) \right) * V_{ss}$$

Accordingly, in an embodiment, a first ratio of the equivalent capacitance of the second drain-to-source capacitance Cds2, the gate-to-drain capacitance Cgd and the gate-to-source capacitance Cgs to the first drain-to-source capacitance Cds1 is based on a second ratio of the drain voltage Vss of the high voltage transistor 10 to a break-down voltage Vbr of the low voltage transistor 12 so as to provide voltage protection for the low voltage transistor 12, in which the break-down voltage Vbr of the low voltage transistor 12 is the highest tolerable voltage at the node P that keeps the low voltage transistor 12 from the breakdown condition.

If the threshold voltage Vth_HV of the high voltage transistor 10 is considered, the relation between the first ratio and the second ratio is expressed by:

$$\left( \left( C_{ds2} + C_{gd} + C_{gs} \right) \middle/ \left( C_{ds1} \right) \right) > \left( V_{ss} - V_{br} \right) \middle/ \left( V_{br} + V_{th\_HV} \right)$$

In an embodiment, the system voltage Vss ranges from 100V to 1200V. The break-down voltage Vbr ranges from 30V to 40V and the threshold voltage Vth_HV of the high voltage transistor 10 ranges from -20V to 5V. Under such a condition, the range of the first ratio is expressed by:

$$5 < \left( \left( C_{ds2} + C_{gd} + C_{gs} \right) / \left( C_{ds1} \right) \right) < 120 \, ,$$

in which the first ratio is less than approximately 120 and is larger than approximately 5.

Consequently, the cascode switch device 1 illustrated in FIG. 1 having the first ratio of the equivalent capacitances being based on the second ratio of the drain voltage Vss of the high voltage transistor 10 to the break-down voltage Vbr of the low voltage transistor 12 provides the voltage protection for the low voltage transistor 12.

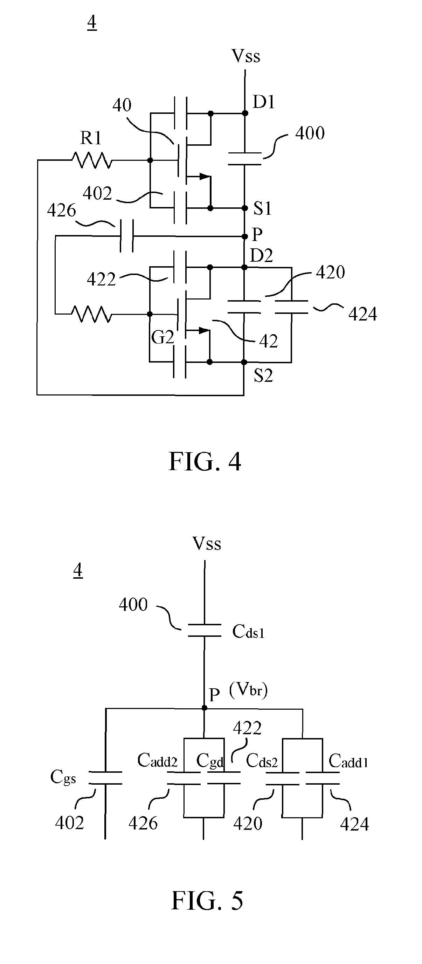

FIG. 4 is a cascode switch device 4 in an embodiment of the present invention. Similar to the cascode switch device 1 illustrated in FIG. 1 and FIG. 2, the cascode switch device 4 includes a high voltage transistor 40 and a low voltage transistor 42.

The high voltage transistor 40 and the low voltage transistor 42 are substantially the same as the high voltage transistor 10 and the low voltage transistor 12 illustrated in FIG. 2, in which the high voltage transistor 40 includes a drain-to-source equivalent capacitor 400 and a gate-to-source equivalent capacitor 402, and the low voltage transistor 42 includes a drain-to-source equivalent capacitor 420 and a gate-to-drain equivalent capacitor 422. Therefore, no further detail is discussed herein.

In the present embodiment, the cascode switch device 4 further includes a first additional capacitor 424 and a second additional capacitor 426. The first additional capacitor 424 is connected between the second drain electrode D2 and the second source electrode S2 of the low voltage transistor 42. The second additional capacitor 426 is connected between the second gate electrode G2 and the second drain electrode D2 of the low voltage transistor 42.

FIG. 5 is a diagram of an equivalent circuit 4 of the capacitors in FIG. 4 in an embodiment of the present invention. In FIG. 5, the capacitances of these capacitors are labeled.

As a result, the second drain-to-source capacitance Cds2 is contributed by the internal capacitance Cds_si of a drain-to-source equivalent capacitor 420 of the low voltage transistor 42 and a capacitance Cadd1 of the first additional capacitor 424. The gate-to-drain capacitance Cgd is contributed the internal capacitance Cgd_si of the gate-to-drain equivalent capacitor 422 and a capacitance Cadd2 of the second additional capacitor 426.

Accordingly, when the capacitances of the drain-to-source equivalent capacitor 420, the gate-to-drain equivalent capacitor 422 and the gate-to-source equivalent capacitor 402 do not meet the requirement mentioned above, the first additional capacitor 424 and the second additional capacitor 426 can be used to meet the requirement.

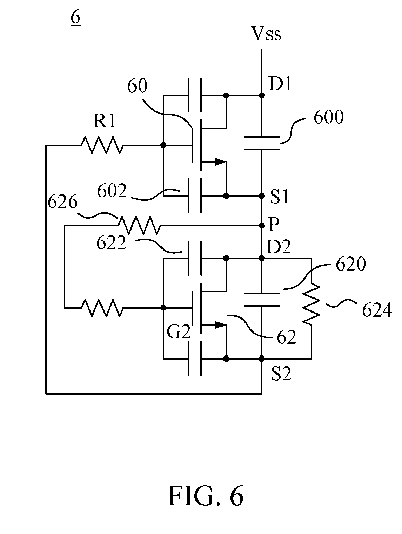

FIG. 6 is a cascode switch device 6 in an embodiment of the present invention. Similar to the cascode switch device 1 illustrated in FIG. 1 and in FIG. 2, the cascode switch device 6 includes a high voltage transistor 60 and a low voltage transistor 62.

The high voltage transistor 60 and the low voltage transistor 62 are substantially the same as the high voltage transistor 10 and the low voltage transistor 12 illustrated in FIG. 2, in which the high voltage transistor 60 includes a drain-to-source equivalent capacitor 600 and a gate-to-source equivalent capacitor 602, and the low voltage transistor 62 includes a drain-to-source equivalent capacitor 620 and a gate-to-drain equivalent capacitor 622. Therefore, no further detail is discussed herein.

In the present embodiment, the cascode switch device 6 further includes a first additional resistor 624 and a second additional resistor 626. The first additional capacitor 624 is connected between the second drain electrode D2 and the second source electrode S2 of the low voltage transistor 62. The second additional capacitor 626 is connected between the second gate electrode G2 and the second drain electrode D2 of the low voltage transistor 42.

Since the leakage current of the high voltage transistor 10 is much larger than the leakage current of the low voltage transistor 12, the low voltage transistor 12 may suffer from the breakdown condition due to the voltage Vp at the point P that increases dramatically when the low voltage transistor 12 turns off. Therefore, the first additional resistor 624 provides a current discharging mechanism.

As a result, in order to perform the current discharging through the first additional resistor 624, the off-resistance of the low voltage transistor 12 needs to be larger than the resistance of the first additional resistor 624. On the other hand, in order not to affect the normal operation when the low voltage transistor 12 turns on, the on-resistance of the low voltage transistor 12 needs to be smaller than the resistance of the first additional resistor 624.

The second additional resistor 626 provides the similar function as the first additional resistor 624. Therefore, no further detail is discussed herein.

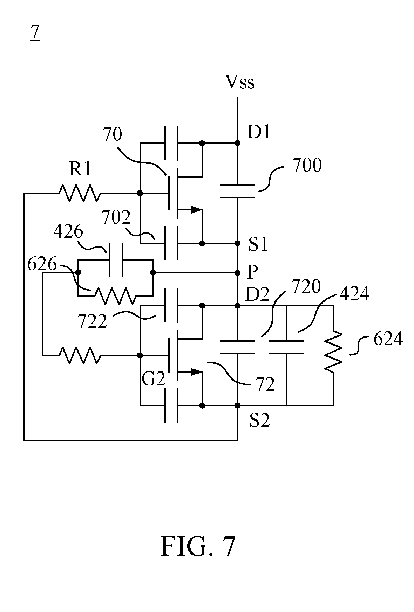

FIG. 7 is a cascode switch device 7 in an embodiment of the present invention. Similar to the cascode switch device 1 illustrated in FIG. 1 and in FIG. 2, the cascode switch device 7 includes a high voltage transistor 70 and a low voltage transistor 72.

The high voltage transistor 70 and the low voltage transistor 72 are substantially the same as the high voltage transistor 10 and the low voltage transistor 12 illustrated in FIG. 2, in which the high voltage transistor 70 includes a drain-to-source equivalent capacitor 700 and a gate-to-source equivalent capacitor 702, and the low voltage transistor 72 includes a drain-to-source equivalent capacitor 720 and a gate-to-drain equivalent capacitor 722. Therefore, no further detail is discussed herein.

In the present embodiment, the cascode switch device 7 further includes the first additional capacitor 424 and the second additional capacitor 426 illustrated in FIG. 4 and the first additional resistor 624 and the second additional resistor 626 illustrated in FIG. 6. Therefore, the cascode switch device 7 can meet the requirement mentioned above by using the first additional capacitor 424 and the second additional capacitor 426 and perform the current discharging mechanism by using the first additional resistor 624 and the second additional resistor 626.

It is noted that the number of the additional capacitors and the additional resistors can be different according to the practical conditions and is not limited by the embodiments mentioned above.

Although the present invention has been described in considerable detail with reference to certain embodiments thereof, other embodiments are possible. Therefore, the spirit and scope of the appended claims should not be limited to the description of the embodiments contained herein.

It will be apparent to those skilled in the art that various modifications and variations can be made to the structure of the present invention without departing from the scope or spirit of the invention. In view of the foregoing, it is intended that the present invention cover modifications and variations of this invention provided they fall within the scope of the following claims.

## Claims

1. A cascode switch device, comprising:

   a high voltage (HV) transistor having a first drain electrode, a first source electrode, and a first gate electrode; and
   a low voltage (LV) transistor having a second drain electrode, a second source electrode, and a second gate electrode, the low voltage transistor cascoded with the high voltage transistor such that the first source electrode is electrically connected to the second drain electrode;
   wherein the casode switch device has a first drain-to-source capacitance between the first source electrode and the first drain electrode, a gate-to-source capacitance between the first gate electrode and a first source electrode, a second drain-to-source capacitance between the second drain electrode and the second source electrode, and a gate-to-drain capacitance between the second gate electrode and the second drain electrode; and
   wherein a first ratio of an equivalent capacitance of the second drain-to-source capacitance, the gate-to-drain capacitance and the gate-to-source capacitance to the first drain-to-source capacitance is based on a second ratio of a drain voltage of the high voltage transistor to a break-down voltage of the low voltage transistor so as to provide voltage protection for the low voltage transistor.

2. The cascode switch device of claim 1, wherein the first ratio is less than approximately 120.

3. The cascode switch device of claim 1, wherein the first ratio is larger than approximately 5.

4. The cascode switch device of claim 1, wherein the high voltage transistor is a III-nitride power transistor.

5. The cascode switch device of claim 1, wherein the low voltage transistor is a silicon-based field-effect transistor.

6. The cascode switch device of claim 1, wherein the high voltage transistor and the low voltage transistor are both nitride-based transistors.

7. The cascode switch device of claim 6, wherein the high voltage transistor and the low voltage transistor are monolithically formed on a same substrate.

8. The cascode switch device of claim 1, wherein the second source electrode is connected to the first gate electrode.

9. The cascode switch device of claim 1, wherein the second drain-to-source capacitance is contributed by an internal capacitance between the second drain electrode and the second source electrode of the low voltage transistor.

10. The cascode switch device of claim 1, further comprising a first additional resistor connected between the second drain electrode and the second source electrode of the low voltage transistor.

**11.** The cascode switch device of claim 10, wherein an on-resistance of the low voltage transistor is smaller than a resistance of the first additional resistor and an off-resistance of the low voltage transistor is larger than the resistance of the first additional resistor.

**12.** The cascode switch device of claim 1, wherein the second drain-to-source capacitance is contributed by an internal capacitance of the low voltage transistor and a capacitance of a first additional capacitor connected between the second drain electrode and the second source electrode of the low voltage transistor.

**13.** The cascode switch device of claim 1, wherein the gate-to-drain capacitance is contributed by an internal capacitance between the second gate electrode and the second drain electrode of the low voltage transistor.

**14.** The cascode switch device of claim 13, further comprising a second additional resistor connected between the second gate electrode and the second drain of the low voltage transistor.

**15.** The cascode switch device of claim 1, wherein the gate-to-drain capacitance is contributed by an internal capacitance of the low voltage transistor and a capacitance of a second additional capacitor connected between the second gate electrode and the second drain of the low voltage transistor.

**16.** A cascode switch device, comprising:

a normally-on high voltage transistor having a first drain electrode, a first source electrode, and a first gate electrode; and
a normally-off low voltage transistor having a second drain electrode, a second source electrode, and a second gate electrode, the normally-off low voltage transistor cascoded with the normally-on high voltage transistor;
wherein the casode switch device has a first drain-to-source capacitance between the first source electrode and the first drain electrode, a gate-to-source capacitance between the first gate electrode and a first source electrode, a second drain-to-source capacitance between the second drain electrode and the second source electrode, and a gate-to-drain capacitance between the second gate electrode and the second drain electrode; and
wherein a first ratio of an equivalent capacitance of the second drain-to-source capacitance, the gate-to-drain capacitance and the gate-to-source capacitance to the first drain-to-source capacitance being based on a second ratio of a drain voltage of the normally-on high voltage transistor to a break-down voltage of the normally-off low voltage transistor so as to provide voltage protection for the normally-off low voltage transistor.

FIG. 1

FIG. 2

FIG. 3

4

FIG. 4

FIG. 5

FIG. 6

FIG. 7